# EUROPEAN PATENT APPLICATION

(11) **EP 4 485 534 A1**
(43) Date of publication of application: **01.01.2025**
(21) Application number: 23923205.1
(22) Date of filing: 12.05.2023
(51) Int. Cl.: H01L 27/10

(54) **SEMICONDUCTOR DEVICE AND MANUFACTURING METHOD THEREFOR, MEMORY AND STORAGE SYSTEM**

(71) Applicant: Yangtze Memory Technologies Co., Ltd., Wuhan, Hubei 430205 (CN)
(72) Inventor: XIE, Wei, Wuhan, Hubei 430205 (CN); MEI, Guozhu, Wuhan, Hubei 430205 (CN); MO, Ping, Wuhan, Hubei 430205 (CN); ZHANG, Jing, Wuhan, Hubei 430205 (CN); LIU, Lei, Wuhan, Hubei 430205 (CN); ZHANG, Kun, Wuhan, Hubei 430205 (CN)
(74) Representative: Lippert Stachow Patentanwälte Rechtsanwälte
(86) International application number: PCT/CN2023/094049
(87) International publication number: WO 2024/234181

(57) **Abstract**

The present application discloses a semiconductor device and a fabrication method thereof, and a memory and a memory system. At least one cleavage plane guide structure extending along a second direction is disposed in a first dicing lane block adjacent to a first device block in a first direction in the semiconductor device, the second direction intersects the first direction, and the cleavage plane guide structure includes a first portion and a second portion that extend along the second direction, and the second portion has higher cleavage plane passability than the first portion. As such, a chip can cleave according to a preset direction and portion when stealth dicing is performed on the chip.

## Description

### TECHNICAL FIELD

The present application relates to the technical field of semiconductors, and particularly to a semiconductor device and a fabrication method thereof, and a memory and a memory system.

### BACKGROUND

A wafer may undergo three transformation processes before it becomes a real semiconductor chip: first, a block-shaped ingot is sliced into wafers; during a second process, transistors are formed on a front side of the wafer through the front end of line; and finally, packaging is performed, i.e., the wafer becomes a complete semiconductor chip through a dicing process. It can be seen that the packaging process belongs to the back end of line in which the wafer will be diced into several individual chips in a hexahedron shape. Such a process of obtaining the separate chips is called "singulation", and a process of sawing a wafer into separate cuboids is called "die sawing". Recently, with the increase of the semiconductor integration level, wafer thickness becomes increasingly thinner, which brings many difficulties to the "singulation" process.

The packaging process of a 3D NAND chip especially faces a higher level of difficulty. As the number of layers of memory arrays in the 3D NAND chip multiplies, the problem that losses are caused by unnecessary cracks generated by the chip becomes more and more serious.

### SUMMARY

Examples of the present application provide a semiconductor device and a fabrication method thereof, and a memory and a memory system, which can solve the technical problem that a chip cannot cleave along a designated direction during stealth dicing of the chip in the existing technology.

In an aspect, examples of the present application provide a semiconductor device, comprising:
a first semiconductor structure that comprises a first device block and a first dicing lane block adjacent to the first device block in a first direction,
wherein the first dicing lane block comprises at least one cleavage plane guide structure extending along a second direction that intersects the first direction, and the cleavage plane guide structure comprises a first portion and a second portion that extend along the second direction, and the second portion has higher cleavage plane passability than the first portion.

In some examples, the second portion comprises an air gap.

In some examples, the first portion comprises two ends in the second direction, and comprises a first curved surface interfacing with the second portion, and the first curved surface is recessed toward the first portion relative to the two ends in the first direction.

In some examples, the first portion comprises two ends in the second direction, and the second portion comprises a gap between a virtual cross-section formed by the two ends of the first portion and the first portion.

In some examples, the first portion comprises a first material that includes one of a polymer, silicon carbide (NDC), silicon nitride, ceramic (SiCN) and silicon oxide.

In some examples, the first portion comprises a first material, the second portion comprises a second material, and a Young's modulus of the second material is less than a Young's modulus of the first material.

In some examples, the first material or the second material includes one of a polymer, silicon carbide (NDC), silicon nitride, ceramic (SiCN) and silicon oxide.

In some examples, the first device block comprises a first gate line isolation structure, the cleavage plane guide structure comprises a second gate line isolation structure that comprises the first portion and the second portion, and a width of the second gate line isolation structure on one cross-section in the first direction is greater than a width of the first gate line isolation structure on the cross-section.

In some examples, the first dicing lane block comprises a plurality of stack structures formed by alternately stacking gate layers and interlayer insulation layers in the second direction, and channel structures or dummy channel structures located in the stack structures and spaced apart from the second gate line isolation structure.

In some examples, the first dicing lane block comprises a plurality of the channel structures or dummy channel structures and a plurality of the second gate line isolation structures, and the plurality of channel structures or dummy channel structures are alternately disposed as being spaced apart from the plurality of second gate line isolation structures in the first direction.

In some examples, the first dicing lane block comprises a first X dicing lane block adjacent to the first device block in the first direction, and a first Y dicing lane block adjacent to the first device block in a third direction that intersects the first direction; and the cleavage plane guide structure comprises a first X cleavage plane guide structure on the first X dicing lane block, and a first Y cleavage plane guide structure on the first Y dicing lane block.

In some examples, the cleavage plane guide structure comprises a first end in the second direction and one narrowed portion away from the first end, and a cross-sectional area of the cleavage plane guide structure in the first direction is gradually enlarged in a direction from the narrowed portion to the first end.

In some examples, the semiconductor device further comprises a second semiconductor structure, wherein the second semiconductor structure comprises a second device block and a second dicing lane block, and the first device block and the second device block are stacked and bonded together in the second direction.

In some examples, the second dicing lane block comprises a silicon substrate.

In some examples, the cleavage plane guide structure comprises a first end in the second direction and one narrowed portion away from the first end, and a cross-sectional area of the cleavage plane guide structure in the first direction is gradually enlarged in a direction from the narrowed portion to the first end; and compared with the narrowed portion, the first end is closer to the second dicing lane block of the second semiconductor device.

In some examples, the first dicing lane block has a first thickness, the first device block has a second thickness that is greater than the first thickness, and a back end face of the first dicing lane block facing away from the second dicing lane block is in a recessed shape relative to an end face of the first device block on the same side as the back end face.

In another aspect, examples of the present application provide a fabrication method of a semiconductor device, which comprises:
providing a first semiconductor structure, wherein the first semiconductor structure comprises a first device block and a first dicing lane block adjacent to the first device block in a first direction; and
forming at least one cleavage plane guide structure extending along a second direction in the first dicing lane block, wherein the second direction intersects the first direction, and the cleavage plane guide structure comprises a first portion and a second portion that extend along the second direction, and the second portion has higher cleavage plane passability than the first portion.

In some examples, the forming the cleavage plane guide structure comprises: forming the first portion, and forming the second portion within the first portion, wherein the second portion comprises an air gap.

In some examples, the forming the cleavage plane guide structure comprises: forming the first portion with a first material including one of a polymer, silicon carbide (NDC), silicon nitride, ceramic (SiCN) and silicon oxide.

In some examples, the forming the cleavage plane guide structure comprises: first forming the first portion with the first material, and then forming the second portion with a second material on an inner face of the first portion, wherein a Young's modulus of the second material is less than a Young's modulus of the first material.

In some examples, the forming the first portion with the first material comprises: forming the first portion with one of a polymer, silicon carbide (NDC), silicon nitride, ceramic (SiCN) and silicon oxide; and the forming the second portion with the second material comprises: forming the second portion with one of a polymer, silicon carbide (NDC), silicon nitride, ceramic (SiCN) and silicon oxide.

In some examples, the forming the cleavage plane guide structure comprises: forming a first gate line isolation structure in the first device block; and forming, in the first dicing lane block, a second gate line isolation structure that acts as the cleavage plane guide structure and comprises the first portion and the second portion, wherein a width of the second gate line isolation structure on one cross-section in the first direction is set to be greater than a width of the first gate line isolation structure on the cross-section.

In some examples, the forming the first dicing lane block comprises: forming a plurality of stack layers formed by alternately stacking sacrificial dielectric layers and interlayer insulation layers in the second direction, and channel structures or dummy channel structures located in the stack layers and spaced apart from a preset position of the second gate line isolation structure.

In some examples, the forming the cleavage plane guide structure comprises: forming a plurality of the second gate line isolation structures, wherein the plurality of second gate line isolation structures are disposed as being spaced apart from the channel structures or the dummy channel structures in the first direction.

In some examples, the method further comprises: providing a second semiconductor structure that comprises a second device block and a second dicing lane block; and stacking and bonding the first device block and the second device block together in the second direction.

In some examples, the providing the second semiconductor structure comprises: providing a silicon substrate, wherein the second dicing lane block comprises the silicon substrate.

In some examples, the method further comprises: removing an end of a side of the first dicing lane block facing away from the second dicing lane block to form a first dicing lane block with a thinned end face, wherein a thickness of the first dicing lane block with the thinned end face in the second direction is less than a thickness of the first device block in the second direction.

In another aspect, examples of the present application provide a memory comprising:
a memory array comprising the first semiconductor structure or the second semiconductor structure in the aforementioned semiconductor device, and
a peripheral circuit comprising the first semiconductor structure or the second semiconductor structure in the aforementioned semiconductor device.

In yet another aspect, examples of the present application provide a memory system, comprising:
the aforementioned memory; and
a control device configured to control operations of the memory.

According to the semiconductor device and the fabrication method thereof, and the memory and the memory system as disclosed in the examples of the present application, the cleavage plane guide structure is designed on the dicing lane, and the first portion and the second portion with two different levels of cleavage easiness are disposed in the cleavage plane guide structure, with the second portion having higher cleavage plane passability than the first portion. By such a configuration, during a stealth dicing before grinding (SDBG) process, cleavage in the dicing lane block will first pass through the weaker second portion, thereby avoiding the situation that a large amount of metal in the dicing lane block cannot break apart in the traditional solution, and thus increasing the dicing yield of products without increasing costs.

### BRIEF DESCRIPTION OF THE DRAWINGS

In order to illustrate the technical solutions in some examples of the present application more clearly, the drawings to be used in description of some examples of the present application will be briefly introduced below. Apparently, the drawings described below are only some examples of the present application. Those of ordinary skill in the art may obtain other drawings according to these drawings without creative work.
FIGs. 1a and 1b are schematic cross-sectional views of a semiconductor device provided by some examples of the present application;
FIGs. 2a to 2c are schematic cross-sectional views of another semiconductor device provided by some examples of the present application;
FIGs. 3a and 3b are distribution diagrams of cleavage plane guide structures in a semiconductor device provided by some examples of the present application;
FIGs. 4a and 4b are schematic cross-sectional views of yet another semiconductor device provided by some examples of the present application;
FIGs. 5a and 5b are flow diagrams of a fabrication method of a semiconductor device provided by some examples of the present application;
FIGs. 6a to 6d are schematic structure diagrams corresponding to various processes as shown in FIG. 5b in a fabrication method of a semiconductor device provided by some examples of the present application;
FIG. 7 is a block diagram of a memory provided by some examples of the present application; and
FIG. 8 is a block diagram of a memory system provided by some examples of the present application.

### DETAILED DESCRIPTION

Specific structures and function details disclosed herein are merely representative, and are for the purpose of describing examples of the present application. However, the present application may be achieved specifically through many alternative forms, and should not be interpreted as being only limited to the examples set forth herein.

In the description of the present application, it is to be understood that, the terms "center", "lateral", "upper", "lower", "left", "right", "vertical", "horizontal", "top", "bottom", "inner", "outer", etc. indicate orientations or position relationships that are based on the orientations or position relationships as shown in the drawings, which are only intended to facilitate description of the present application and to simplify the description, instead of indicating or implying that the device or components indicated must have a specific orientation and be configured and operated in a specific orientation, and thus cannot be understood as limiting the present application. Furthermore, the terms "first" and "second" are only for the purpose of description, and cannot be construed as indicating or implying relative importance or implicitly indicating the number of indicated technical features. Thus, features defined by "first" and "second" may explicitly or implicitly include one or more of such features. In the description of the present application, "a plurality of' means two or more, unless otherwise stated. In addition, the term "comprise" and any variants thereof are intended to encompass the non-exclusive "including".

Moreover, the prefixes of terms "first" and "second" added to the same kind of devices is only used to distinguish different ones of the devices of the same kind, is only for facilitating expression of relative positions, and does not represent sequentiality or fixity, that is, "first" and "second" have interchangeability, and one of the devices of the same kind may be referred to as "first" and may also be referred to as "second".

In the description of the present application, it is to be noted that, unless otherwise specified and defined expressly, the terms "connected" and "connecting" should be interpreted broadly, which, for example, may be fixed connection, detachable connection, or integrated connection; may be either mechanical connection or electrical connection; may be either direct connection or indirect connection through intermediate media, and may be connection inside two components. Those of ordinary skill in the art may understand the specific meanings of the above terms in the present application according to specific conditions.

The terms as used herein are only used to describe the specific examples, and are not intended to limit the examples. Unless otherwise indicated expressly in the context, the singular forms "a" and "an" used herein are also intended to include plurality. It should be also understood that the terms "comprise" and/or "include", as used herein, specify the presence of the stated features, integers, steps, operations, units and/or components, and do not preclude the presence or addition of one or more of other features, integers, steps, operations, units, components, and/or a combination thereof.

In order to minimize the influence of grinding and scribing processes in packaging on a chip with poor strength, the present application employs a stealth dicing before grinding (SDBG) process, that is, the chip generates a stealth crack at a specific portion through stealth dicing, then back grinding is performed so that the chip reaches a designated thickness, and then a wafer or a die cleaves along a preset direction by pulling apart two sides of the stealth crack, thereby finishing the dicing of the wafer or the die. Such a process can avoid mechanical damage to the chip caused by blade dicing.

For improving the strength of the chip, the chip dicing technology of SDBG (stealth dicing before grinding) is a trend of future 3D NAND package dicing, but is not limited to 3D NAND. Compared with the traditional DBG (dicing before grinding, i.e., a technology of first performing semi-dicing processing on the chip and then dividing the chip into chiplets using back grinding), the SDBG obviously reduces the requirements for the chip strength.

However, it is found by the present application through research that with the increase of the number of layers of the 3D NAND, a total thickness of films in a Z direction of a stack becomes thicker and thicker. Moreover, some tiny array test keys are distributed on a dicing lane, and such test keys contain many word line metals, which results in the problem of failure in cutting of the SDBG, thereby affecting the product yield.

The SDBG is a stealth dicing method through laser exposure from the back of a substrate, and laser light is focused to heat and melt a silicon material to generate a thermal expansion force, such that the substrate cleaves along a dicing line generated by the expansion force, so as to achieve wafer dicing. However, if the wafer has many continuous metal films, due to the strong ductility of metal and the toughness in fracture of metal, the effect of the SDBG dicing will be affected, and the wafer cannot be cut apart in a serious case. Moreover, thickened metal layers will prevent the chip from cleaving along a designated direction during the stealth dicing, thus resulting in dice or chip damage. Even if the laser energy of the SDBG is increased for dicing, the laser energy has a certain upper limit, and the costs of this solution will be increased accordingly.

A gate line isolation structure is typically disposed in, for example, a 3D NAND memory array. The present application not only achieves an obviously increased success window of the SDBG dicing process, but also increases the product dicing yield through a new special gate line isolation structure design, without increasing the costs.

Hereinafter, the semiconductor device and the fabrication method thereof, and the memory and the memory system provided by the present application will be disclosed through some examples.

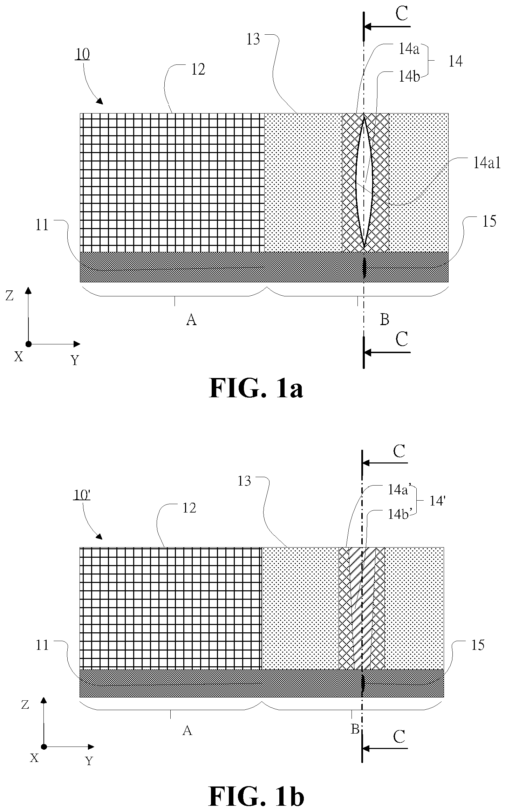

Fist, as shown in FIGs. 1a to 1b, disclosed is a semiconductor device according to some examples of the present application, and particularly disclosed are various structures that is favorable to dice wafers using an SDBG (stealth dicing before grinding) process.

For the semiconductor device according to some examples of the present application, first, a fundamental semiconductor device is provided. As shown in FIG. 1a, the semiconductor device as disclosed by examples of the present application comprises: a first semiconductor structure 10 comprising a first device block 12 and a first dicing lane block 13 adjacent to the first device block in a first direction, wherein the first dicing lane block 13 comprises at least one cleavage plane guide structure 14 extending along a second direction; the second direction intersects the first direction, and the cleavage plane guide structure 14 comprises a first portion 14a and a second portion 14b that extend along the second direction and are at least partially in juxtaposition, and the second portion 14b has higher cleavage plane passability than the first portion 14a.

In an example, as shown in FIG. 1a, the first device block 12 and the first dicing lane block 13 adjacent to the first device block in the first direction Y may comprise a common substrate 11. The first device block 12 includes any possible device structure formed on a region A of the substrate, and the first dicing lane block 13 includes any possible dicing lane structure formed on a region B of the substrate in order to match the device structure on the region A. In addition, the first dicing lane block 13 comprises one cleavage plane guide structure 14 extending through the dicing lane structure along the second direction Z and extending along a third direction X. The cleavage plane guide structure 14 comprises the first portion 14a formed by a first material, including, but not limited to, one of a polymer, silicon carbide (NDC), silicon nitride (SiN), ceramic (SiCN) and silicon oxide (SiO₂).

The aforementioned cleavage plane refers to a cleavage plane that is generated when the substrate cleaves along a dicing line C-C of the cleavage plane guide structure 14 with a stealth crack as a starting point in a subsequent process so as to achieve the dicing of the wafer, wherein the stealth crack is caused by a thermal expansion force that is generated when focusing of laser light heats and melts a silicon material of the substrate. The external laser light is applied to a focal point 15 in FIG. 1a from a side of the substrate 11 facing away from a dicing lane structure of the first dicing lane block 13. The cross-sectional line C-C is a position where the cleavage plane expected to be generated corresponding to the position of the laser focal point is located, and its cleavage portion is the cleavage plane.

In the example as shown in FIG. 1a, the second portion 14b is an air gap that is formed at the same time as the formation of the first portion 14a of the cleavage plane guide structure 14. That is, the air gap acting as the second portion 14b may be properly formed in the first portion 14a by properly adjusting a deposition speed of a material of the first portion 14a.

It is to be noted here that, in an actual product, the substrate 11 may be replaced by other film layers, or may be removed in a subsequent fabrication process such that the finally formed semiconductor device does not have the substrate 11. Therefore, the first device block 12 and the first dicing lane block 13 may not comprise the substrate 11 either. When the substrate is included, a material of the substrate 11 may comprise monocrystalline silicon, polysilicon, monocrystalline germanium, a group III-V compound semiconductor material, a group II-VI compound semiconductor material, or other semiconductor materials. In other examples, the semiconductor substrate may also be a substrate comprising other elemental semiconductors or compound semiconductors, or may be a deck structure, such as Si/SiGe, silicon on insulator (SOI), or germanium on insulator (GOI), etc. Therefore, the substrate 11 may be a single-layer structure, or may be a multi-layer composite structure, which is not limited specifically herein.

In addition, the first device block 12 may comprise various semiconductor structures, for example, semiconductor structures consisting of various memory arrays or digital circuits. The semiconductor structures consisting of the memory arrays may include, but not be limited to, 2D or 3D memory array semiconductor structures, such as NAND, DRAM, FeRAM, PCRAM, MRAM, etc. The digital circuits may include, but not be limited to, semiconductor structures consisting of analog integrated circuit devices such as controllers, power amplifiers, power management circuits, etc., or digital integrated circuit devices such as programmable logic devices (PLDs), microprocessors (MPUs), microcontrollers (MCUs), digital signal processors (DSPs), etc.

The dicing lane structure in the first dicing lane block 13 may comprise various possible test key structures, or may be a dicing lane structure formed by accumulation in the dicing lane in order to match a configuration of the first device block 12.

It is to be further noted here that, the so-called semiconductor device in the present application may refer to a wafer, or may refer to a die or a chiplet after wafer dicing, or a chip after finishing packaging. However, in this specification, for ease of expression and illustration, an expression is made only with a portion of the wafer, the die or the chip related to the dicing lane. Most of reference numerals as shown show a scenario that a wafer includes the device block and the dicing lane block that are adjacent. However, those skilled in the art may understand that, after two adjacent dies in the wafer cleave through the cleavage plane in the dicing lane, a single die will be one die on one of two sides of the cleavage plane. Therefore, when it refers to a wafer, the semiconductor device will be a semiconductor device comprising at least one first device block 12 and one complete first dicing lane block 13. However, when the semiconductor device refers to one of the dies or the chips after dicing, the semiconductor device will only comprise one first device block 12 and part of the first dicing lane block 13, i.e., part of the first dicing lane block 13 cut along the cross-sectional line C-C.

Therefore, when the second portion 14b is an air gap in the example as shown in FIG. 1a, if the semiconductor device is a single die or chip, only the region A and part of the region B are presented, i.e., only one first device block 12 and part of the first dicing lane block 13 are presented, and part of the first dicing lane block 13 will only comprise part of the first portion 14a and part of the second portion 14b. For example, the first portion 14a may comprise two ends (not numbered) in the second direction Z, and part of the first portion 14a will only comprise part of the first portion 14a on a side of an interface as labeled by the illustrated cross-sectional line C-C close to the first device block 12. The air gap as the second portion 14b will only present or represent the presence of part of the air gap or part of the second portion through one first curved surface 14a1 on the first portion 14a interfacing with the first portion 14a, and the first curved surface 14a1 is recessed toward the first portion 14a relative to the two ends in the first direction Y. In other words, when the semiconductor device is a single die or chip, the presence of "part of the first portion" represents the presence of the first portion, that is, the first portion comprises "part of the first portion". The presence of "part of the second portion" represents the presence of the second portion, that is, the second portion comprises "part of the second portion", and the first curved surface 14a1 is recessed toward the first portion 14a relative to the two ends in the first direction Y.

In addition, it is to be noted that, for the presence of the stealth part of the second portion 14b, it may also means that the first portion 14a comprises two ends (not numbered) in the second direction, and the second portion 14b comprises a gap between a virtual cross-section (i.e., the cross-sectional line C-C) formed by the two ends of the first portion 14a and the first portion 14a, that is, a space between the cross-sectional line C-C and the first curved surface 14a1.

Furthermore, in some examples, as shown in FIG. 1b, the cleavage plane guide structure 14' comprises a first portion 14a' and a second portion 14b' that extend along the second direction and are at least partially in juxtaposition, wherein the first portion 14a' comprises a first material, the second portion 14b' comprises a second material, and a Young's modulus of the second material is less than a Young's modulus of the first material.

In particular, the Young's modulus E as shown is also called an elastic modulus, and is a term in mechanics of materials. An elastic material will generate forward strain when bearing forward stress. When an amount of deformation does not exceed a certain elastic limit of the corresponding material, a ratio of the forward stress to the forward strain is defined as the Young's modulus of this material. Moreover, the Young's modulus depends on the composition of the material. For example, the Young's moduli of most metals have a 5% or greater fluctuation due to different alloy compositions and different heat treatment during processing. The first material and the second material each may include, but not be limited to, one of a polymer, silicon carbide (NDC), silicon nitride, ceramic (SiCN) and silicon oxide, and are different materials.

In particular, the Young's modulus E of the ceramic (SiCN) is about 450 GPa, the Young's modulus E of silicon carbide (SiC) is about 330 GPa, the Young's modulus E of silicon nitride is about 300 GPa, the Young's modulus E of silicon oxide is about 72 GPa, and the Young's modulus E of the polymer is about less than 10 GPa. Therefore, when the air gap of FIG. 1a is not used as the second portion, but the first material and the second material that are different materials are used as the first portion and the second portion respectively, for example, a polymer for the material of the second portion, and silicon nitride for the material of the first portion, a combination with the Young's modulus of the second material being less than the Young's modulus of the first material, or a combination with the second portion having higher cleavage plane passability than the first portion as described previously may be obtained.

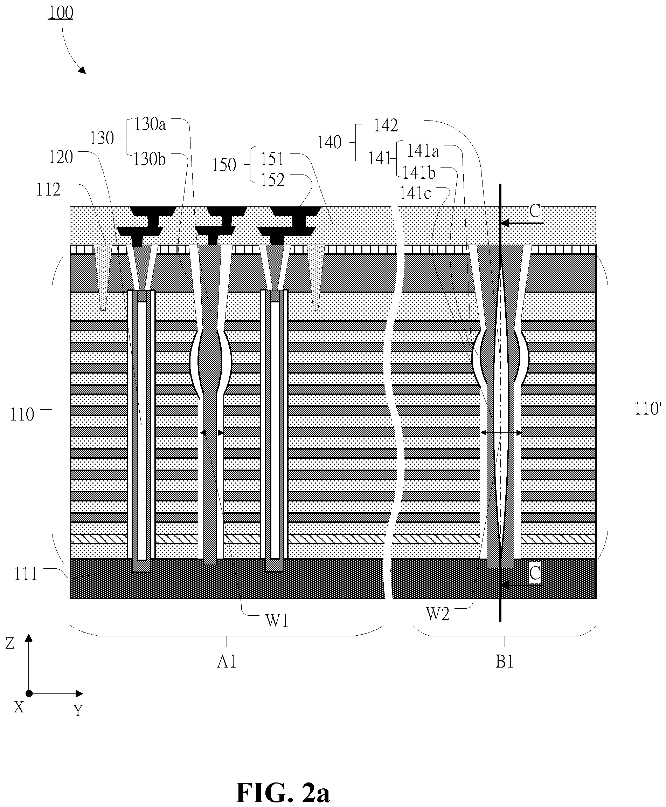

Based on the aforementioned fundamental design, some other examples of the present application are further illustrated below. First, as shown in FIG. 2a, the semiconductor device as shown in examples of the present application comprises a first semiconductor structure 100, and the first semiconductor structure 100 comprises a first device block A1 and a first dicing lane block B1 adjacent to the first device block A1 in a first direction (compared with FIG. 1a, the blocks are represented by A1 and B1). The first device block A1 and the first dicing lane block B1 are formed on a substrate 111, and a material of the substrate is as described previously, and is no longer described in detail. The structure as shown in FIG. 2a is illustrated by an example in which the first semiconductor structure is applied in a 3D NAND. In this example, the first device block A1 comprises a first gate line isolation structure 130, and the first dicing lane block B1 comprises a second gate line isolation structure 140 extending along the second direction Z as a cleavage plane guide structure. The second gate line isolation structure 140 comprises a first portion 141 and a second portion 142 corresponding to the aforementioned first portion 14a and the second portion 14b respectively, and a width W2 of the second gate line isolation structure 140 on one cross-section in the first direction Y is greater than a width W1 of the first gate line isolation structure on the cross-section.

In an example, the first device block A1 in the first semiconductor structure 100 comprises a stack structure 110, as well as a plurality of channel structures 120, a plurality of first gate line isolation structures 130 and top gate isolation structures 112 that penetrate through the stack structure 110. The stack structure 110 comprises gate layers and interlayer insulation layers (not numbered) stacked alternately. The gate layers 101 include, but are not limited to, tungsten, cobalt, copper, aluminum, doped silicon or doped silicide, and the interlayer insulation layers include, but are not limited to, a combination of any of one or more of silicon oxide, silicon nitride and silicon oxynitride. The number of the gate layers and the interlayer insulation layers may be any number and is not limited.

The channel structures 120 penetrate through the gate layers and the insulation layers along a stacking direction (Z) (i.e., the second direction). The channel structures 120 may comprise a channel filling layer, a channel layer disposed around the channel filling layer, and a storage medium layer disposed around the channel layer (the above-mentioned layers are not focuses of the present application, and thus are not numbered in detail) from inside to outside. The storage medium layer may comprise a tunneling layer disposed around the channel layer, a charge storage layer disposed around the tunneling layer, and a charge blocking layer disposed around the charge storage layer (again, these layers are not shown in the figures since they are not focuses of the present application). The channel filling layer may comprise an oxide, such as silicon oxide, silicon nitride, silicon oxynitride, etc. The channel layer may comprise a semiconductor layer, such as polysilicon. The tunneling layer may comprise an oxide, such as silicon oxide, silicon nitride, silicon oxynitride, etc. The charge storage layer may comprise an insulation layer including a compound containing quantum dots or nanocrystals or containing nitrogen and silicon. The charge blocking layer may comprise an oxide, such as silicon oxide, etc.

The first gate line isolation structures 130 are gate line isolation structures formed in gate slits (not numbered) formed in the stack structure 110 through a thin film deposition process. The first gate line isolation structures 130 may comprise a filling layer 130a and a barrier layer 130b, wherein the filling layer 130a extends from a side of the stack structure 110 facing away from the substrate 111 into the substrate 111, and the barrier layer 130b is disposed around the filling layer 130a. A material of the barrier layer 130b may comprise at least one of silicon oxide, silicon nitride, silicon oxynitride, doped silicon oxide, organosilicate glass, and other materials. A material of the filling layer 130a may include, but not be limited to, a polymer material such as polysilicon, etc. When it is a polymer layer, the filling layer 130a has a conductive effect, and can act as a leading-out structure of a common source. In addition, a cross-section in the first direction Y of any portion of the first gate line isolation structures 130 in the second direction Z has a first width W1.

The top gate isolation structures 112 are distributed in the top gate layer for memory array paging of the channel structures 120. A material of the top gate isolation structures 112 may include, but not be limited to, a dielectric insulation material, such as silicon oxide, silicon nitride, etc.

In addition, the first semiconductor structure 100 may further comprise an interconnection layer 150. The interconnection layer 150 is mainly distributed on the first device block A1, but may also be distributed on the first dicing lane block B1, and the interconnection layer 150 comprises a dielectric layer 151 and conductive lines or conductors 152 in the dielectric layer 151. A material of the dielectric layer 151 may include, but not be limited to, at least one of silicon oxide, silicon nitride, silicon oxynitride, doped silicon oxide, organosilicate glass, and other materials. A material of the conductive lines or conductors 152 may include at least one of tungsten, cobalt, copper, aluminum, and other materials. The interconnection layer 150 may connect the first gate line isolation structures 130 and the channel structures 120 to other external devices in proper arrangement.

In the first dicing lane block B 1, in order to match the formation of the stack structure 110 on the first device block A1, a similar stack structure 110' is also formed in the first dicing lane block B1. Although the stack structures 110 and 110' are both formed by alternately stacking the gate layers and the interlayer insulation layers in this example, it is to be understood that the gate layers in the first dicing lane block B1 of some examples may be sacrificial dielectric layers not replaced by the gate layers. Thus, the stack structure in the first dicing lane block B1 is labeled as 110' here. The second gate line isolation structure 140 in the first dicing lane block B1 as the cleavage plane guide structure is formed in the stack structure 110', and like the second portion 14b as shown in FIG. 1a, the second portion 142 in the second gate line isolation structure 140 is an air gap. The first portion 141 is the same as the first gate line isolation structures 130 in structure, and comprises a filling layer 141a, and an oxidization layer 141b isolating the filling layer 141a from the stack structure 110'. A material of the first portion 141 may be the same as the material of the first gate line isolation structures 130, but a material of the filling layer 141a in the oxidization layer 141b may include, but not be limited to, one of a polymer, silicon carbide (NDC), silicon nitride, ceramic (SiCN) and silicon oxide. That is, the first portion 141 may be formed simultaneously with the first gate line isolation structures 130 and uses the same material as the first gate line isolation structures 130, but may also be formed separately by using a material different from that of the first gate line isolation structures 130.

In addition, a cross-section in the first direction Y of any portion of the second gate line isolation structure 140 in the second direction Z has a second width W2, and the second width W2 is greater than the first width W1. In some examples, a width range, i.e., a second width, of the second gate line isolation structure 140 may be between 200 nm and 2 µm. Through the setting that the second width W2 is greater than the first width W1, when the second gate line isolation structure 140 and the first gate line isolation structures 130 are formed simultaneously, on the one hand the first gate line isolation structures 130 can be fully filled, and on the other hand an air gap as the second portion 142 may be also formed in the first portion 141 of the second gate line isolation structure 140. Obviously, since the second portion 142 is the air gap, the second portion 142 will have higher cleavage plane passability than the first portion 141.

Through the aforementioned second gate line isolation structure 140 as the cleavage plane guide structure, when external laser light is applied to a position corresponding to a focal point 15 where the air gap is located as similar to FIG. 1a from a side of the substrate 111 facing away from the stack structure 110' in the first dicing lane block B1, focusing of the laser light will heat and melt the silicon material that serves as the substrate and generate a thermal expansion force, such that the substrate cleaves through the air gap along the dicing line C-C in a subsequent process, thereby achieving wafer dicing.

The aforementioned second gate line isolation structure 140 may be a special gate line isolation structure. When this special second gate line isolation structure 140 and the first gate line isolation structures 130 in the first device block A1 are formed simultaneously, the process costs will not be increased. In addition, there is no need to, for example, reserve a 15 µm dicing pathway region between the first device block A1 and the stack structure or a test key structure of the first dicing lane block B 1; instead, the air gap in the second gate line isolation structure 140 guides an extension direction and portion of the crack generated by the laser, and the crack extends and first cleaves along the weakest air gap in the final SDGB dicing process, thereby avoiding the problem of die damage and achieving good wafer or die dicing. Therefore, the structure design as shown in the examples of the present application does not affect test requirements of a Mini Array TSK. Moreover, in the case where the future device block is increasingly wider, there will be a test requirement for the number of the Mini Array TSKs, and it will be more difficult to reserve a 15 µm region. The second gate line isolation structure 140 as the cleavage plane guide structure as shown in the examples of the present application will provide a better solution to the problem.

In this example, like the example as shown in FIG. 1a, since the second portion 142 is an air gap, if the semiconductor device is a single die or chip, only part of the first dicing lane block B1 will be presented, and part of the first dicing lane block B1 will only comprise part of the first portion 141 and part of the second portion 142. For example, the first portion 141 may comprise two ends (not numbered) in the second direction Z, and part of the first portion 141 will only comprise part of the first portion 141 on a side of an interface as labeled by the illustrated cross-sectional line C-C close to the first device block A1. The air gap as the second portion 142 will only present the presence of part of the air gap (i.e., part of the second portion) through one first curved surface 141c on the first portion 141 interfacing with the first portion 141, and the first curved surface 141c is recessed toward the first portion 141 relative to the two ends in the first direction Y. Likewise, when the semiconductor device is a single die or chip, the presence of "part of the first portion" represents the presence of the first portion, that is, the first portion comprises "part of the first portion". The presence of "part of the second portion" represents the presence of the second portion, that is, the second portion comprises "part of the second portion", and the first curved surface 14a1 is recessed toward the first portion 14a relative to the two ends in the first direction Y.

Likewise, for the presence of the stealth part of the second portion 142, it may also means that the first portion 141 comprises two ends (not numbered) in the second direction, and the second portion 142 comprises a gap between a virtual cross-section (i.e., the cross-sectional line C-C) formed by the two ends of the first portion 141 and the first portion 141, that is, a space between the cross-sectional line C-C and the first curved surface 141c.

Additionally, it is to be mentioned here that, the aforementioned first device block A1 taking a 3D NAND array as an example may also comprise a connection area structure. The connection area structure may comprise a plurality of gate layer leading-out contacts for leading out all the gate layers, and the connection area structure may be in various known structure designs, which comprises a staircase structure with staircase-shaped stack layers, or a staircase contact connection (SCT) structure only with the staircase-shaped leading-out contacts. These are not described in detail here since they are not focuses of the present application.

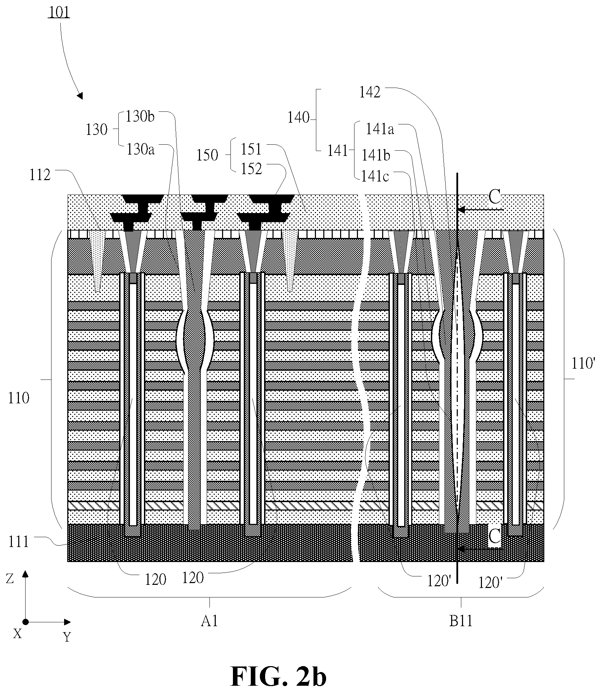

Next, referring to FIG. 2b, FIG. 2b discloses another semiconductor device according to some examples of the present application, and the semiconductor device comprises a first semiconductor structure 101. The first semiconductor structure 101 is similar to the semiconductor structure 100 as shown in FIG. 2a, and also comprises a first device block A1 and a first dicing lane block B11 adjacent to the first device block A1 in a first direction. However, the first dicing lane block B11 differs from the aforementioned first dicing lane block B1 in that: the first dicing lane block B11 comprises channel structures or dummy channel structures 120' formed in a stack structure 110' and spaced apart from the second gate line isolation structure 140 in the first direction Y, in addition to the second gate line isolation structure 140 extending along the second direction Z as a cleavage plane guide structure. Moreover, the number of columns of the channel structures or dummy channel structures 120' arranged in columns in a third direction X may be at least one or more.

The channel structures or dummy channel structures 120' may be formed at the same time as the channel structures 120 in the first device block A1, and may comprise the same structure as the channel structures 120, but may also comprise different structures, for example, not having the channel layer and the storage medium layer in the aforementioned channel structures 120, but only having the filling layer. When the channel structures or dummy channel structures 120' have the same structure as the channel structures 120, the channel structures or dummy channel structures 120' may be called channel structures. The channel structures or dummy channel structures 120' may be called dummy channel structures when only comprising the filling layer. For the first dicing lane block B11 in the first semiconductor structure 101 disclosed in FIG. 2b, since the channel structures or dummy channel structures 120' are additionally disposed in order to match the disposition of the first device block A1, when the first dicing lane block B11 is wide, a good process window may be obtained by matching the disposition of the first device block A1.

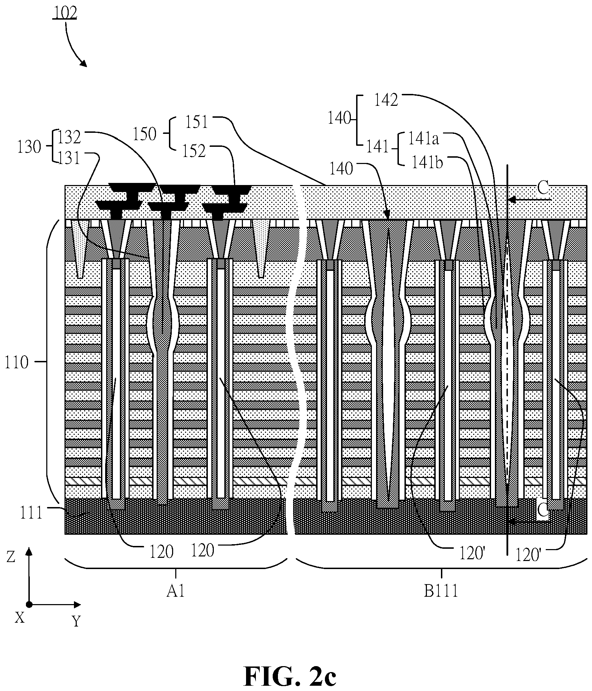

Next, referring to FIG. 2c, FIG. 2c discloses another semiconductor device according to some examples of the present application, and the semiconductor device comprises a first semiconductor structure 102. The first semiconductor structure 102 is similar to the semiconductor structure 101 as shown in FIG. 2b, and also comprises a first device block A1 and a first dicing lane block Bill adjacent to the first device block A1 in a first direction. However, the first dicing lane block B111 differs from the aforementioned first dicing lane block B11 in that: the first dicing lane block B111 comprises a plurality of the second gate line isolation structures 140, in addition to the second gate line isolation structure 140 extending along a second direction Z as a cleavage plane guide structure and channel structures or dummy channel structures 120'. That is, the first dicing lane block B111 differs from the first dicing lane block B11 in the number of the second gate line isolation structures 140.

In addition, in the example as shown in FIG. 2c, the number of columns of the channel structures or dummy channel structures 120' in a third direction X is also greater than the number of the columns of the first dicing lane blocks B11, and the plurality of columns of the channel structures or dummy channel structures are alternately disposed as being spaced apart from the plurality of second gate line isolation structures 140 in the first direction Y.

The semiconductor device or the first semiconductor structure 102 as shown in FIG. 2c may be suitable for a wider dicing lane design, and may also increase selectivity of a cleavage plane. That is, dicing positions may need to be finely adjusted in coordination with the X and Y directions during dicing of the semiconductor device. In this case, when the plurality of second gate line isolation structures 140 as the cleavage plane guide structures are disposed, the adjustability can be increased.

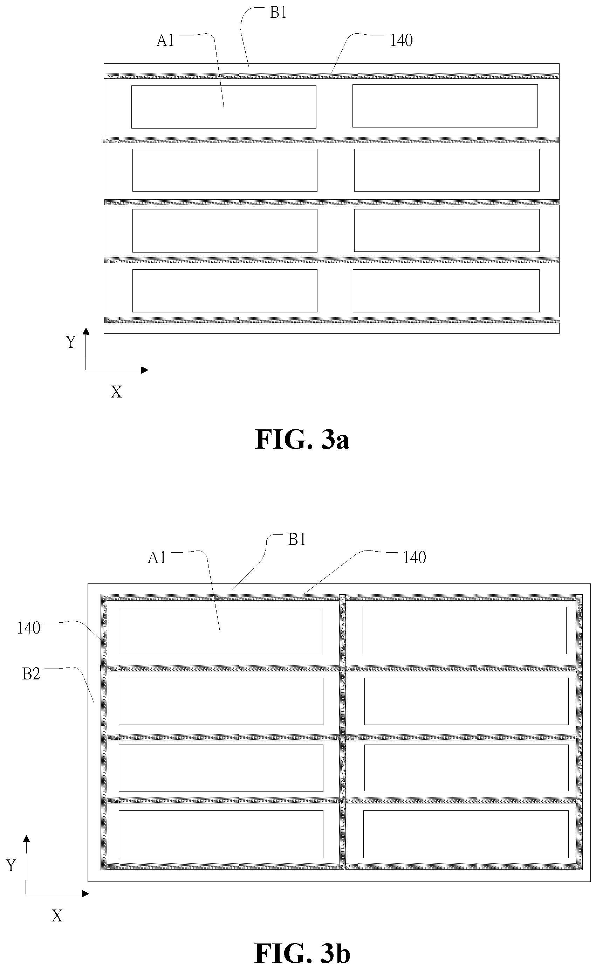

Next, referring to FIGs. 3a and 3b, distribution positions of the cleavage plane guide structures are further viewed from a different angle. FIGs. 3a and 3b disclose the distribution of the cleavage plane guide structures 14 of FIGs. 1a and 1b, or the cleavage plane guide structures 140 of FIGs. 2a to 2c on a plane where the first direction Y and the third direction X are located.

As shown in FIG. 3a, A1 represents the first device block 12 and A1 in each of the aforementioned examples, B1 represents the first dicing lane block B1 and B11 in each of the aforementioned examples, and 140 represents the cleavage plane guide structure 14 and 140 in each of the aforementioned examples. Typically, the first gate line isolation structure 130 in the first device block A1 extends along the X direction as the third direction. Thus, the second gate line isolation structure 140 as the cleavage plane guide structure also extends in the first dicing lane block B1 along the third direction X. As such, the first dicing lane blocks B1 extending along the third direction X but arranged as being spaced apart in the first direction Y are called as first X dicing lane blocks, and the first dicing lane blocks B2 extending along the first direction Y but arranged as being spaced apart in the third direction X are called as first Y dicing lane blocks.

As shown in FIG. 3b again, the second gate line isolation structures 140 as the cleavage plane guide structures extend along the third direction X in the first dicing lane blocks B1, and also extend along the first direction Y in the first Y dicing lane blocks B2 in the Y direction as the first direction. That is, it may be said that the first dicing lane block comprises the first X dicing lane block B1 adjacent to the first device block in the first direction Y, and the first Y dicing lane block B2 adjacent to the first device block in the third direction X, wherein the third direction intersects the first direction; the cleavage plane guide structure 140 comprises a first X cleavage plane guide structure on the first X dicing lane block, and a first Y cleavage plane guide structure on the first Y dicing lane block. The first X cleavage plane guide structure and the first Y cleavage plane guide structure are the same in structure, while only their directions are different. Thus, the first X cleavage plane guide structure and the first Y cleavage plane guide structure are labeled using the same reference numeral 140, instead of using different reference numerals.

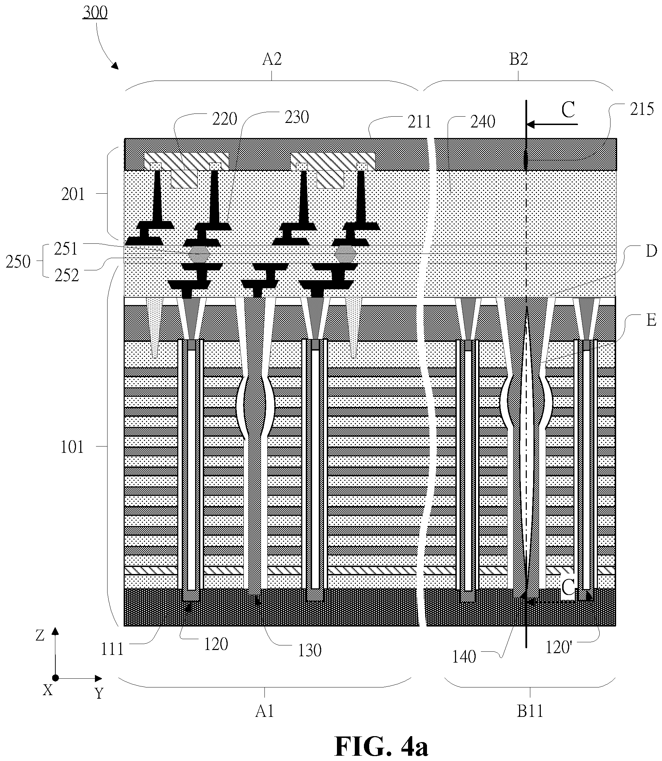

Some fundamental structures of the cleavage plane guide structure as shown in some examples of the present application are specifically disclosed above. Next, referring to FIG. 4a, FIG. 4a discloses a schematic cross-sectional view of another semiconductor device provided by some examples of the present application. The semiconductor device 300 as disclosed in FIG. 4a comprises a semiconductor structure 201, in addition to the aforementioned first semiconductor structure 101. The semiconductor structure 201 comprises a second device block A2 and a second dicing lane block B2, and the first device block A1 and the second device block A2 are stacked and bonded together in the second direction Z.

In an example, the first semiconductor structure 101 is the first semiconductor structure 101 as shown in FIG. 2a, and thus is not repeated here. In this example, the second device block A2 in the second semiconductor structure 201 comprises a substrate 211, second devices 220 on the substrate 211, a conductive route 230 connected with each of the second devices 220, and a dielectric layer 240 covering the second devices 220 and acting as interlayer isolation of the conductive route. A material of the substrate 211 is the same as that of the substrate in the first semiconductor structure 101, and may comprise monocrystalline silicon, polysilicon, monocrystalline germanium, a group III-V compound semiconductor material, a group II-VI compound semiconductor material or other semiconductor materials, etc., which is no longer repeated here. The substrate 211 may extend into the second device block A2 and the second dicing lane block B2.

Furthermore, the first semiconductor structure 101 and the second semiconductor structure 201 are bonded together through a bonding structure 250. The bonding structure 250 may comprise bonding layers located on the first semiconductor structure 101 and the second semiconductor structure 201 respectively, and each of the bonding layers comprises bonding contacts 251 and a dielectric layer 252 (only one reference numeral is used as a common label of the two bonding layers in the figure).

The second device block A2 constitutes a device with a specific function, which may be a peripheral circuit configured to control a memory array in the first semiconductor structure 101, or may be a semiconductor structure consisting of other digital circuits. The digital circuits may include, but not be limited to, semiconductor structures consisting of analog integrated circuit devices such as controllers, power amplifiers, power management circuits, etc., or digital integrated circuit devices such as memory controllers, microprocessors, digital signal processors (DSPs), etc., which is not limited here.

The second dicing lane block B2 also comprises the aforementioned substrate 211 and the dielectric layer 240. The substrate 211 and the dielectric layer 240 in the second dicing lane block B2 may be structures extending into the second dicing lane block B2 in order to match a design of the second device block A2, but may also be a specially formed structure, such as a test key structure as shown previously, etc. It may be understood that, in some examples, a structure of the second dicing lane block B2 may be also provided with the cleavage plane guide structure 14 or 14' that is the same as that as shown in above FIG. 1a or 1b, which is no longer repeated here.

According to the aforementioned semiconductor device 300, as shown in FIG. 4a, external laser light may be applied into the substrate 111 or 211 (e.g., a position of a focal point 215 as shown in the figure) from a side of the substrate 111 or 211 facing away from the first dicing lane block B11 or B2 respectively. The focusing of the laser light will heat and melt the silicon material that serves as the substrate to generate a thermal expansion force, such that the substrate as well as the first dicing lane block B11 and the second dicing lane block B2 cleave along the dicing line C-C under a subsequent tensile force, thereby achieving wafer dicing. The cross-sectional line C-C is a position where the cleavage plane is expected to be generated corresponding to the position of the laser focal point is located.

In some examples, as is shown in FIG. 4a, the cleavage plane guide structure 140 may comprise a first end D in the second direction Z, and one narrowed portion E away from the first end D, and a cross-sectional area of the cleavage plane guide structure 140 in the first direction Y is gradually enlarged in a direction from the narrowed portion E to the first end D. Compared with the narrowed portion E, the first end D is closer to the second dicing lane block B2 of the second semiconductor device 201. A distance between the first end D and the narrowed portion E may be set according to actual situations.

As described previously, an opening of the cleavage plane guide structure 140 close to a laser light incident side is made to be gradually enlarged toward the laser light incident side, such that a cleavage line of the thermal expansion force generated by focusing the laser light on the substrate can enter the cleavage plane guide structure 140 more easily, thereby achieving the objective of dicing through the air gap.

It may be understood that, in the example as shown in FIG. 4a, an enlarged opening end of the cleavage plane guide structure 140 faces the second semiconductor structure 201, but the present application is not limited thereto, and the enlarged opening end may be designed according to actual structures. For example, when the semiconductor device does not comprise the second semiconductor structure, the enlarged opening end of the cleavage plane guide structure 140 may face the substrate that the first semiconductor structure itself comprises, which is favorable to make the cleavage line of the thermal expansion force generated by focusing the laser light on the substrate enter the cleavage plane guide structure 140 more easily.

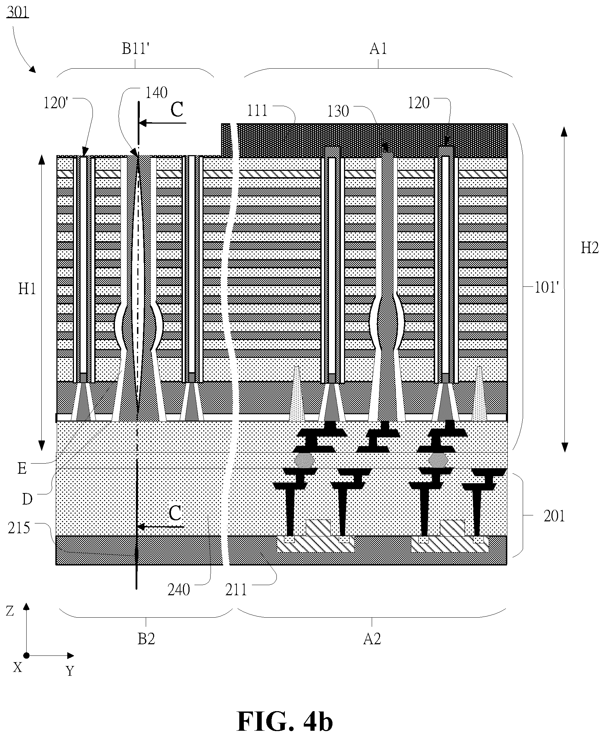

Hereinafter, with continued reference to FIG. 4b, FIG. 4b discloses a schematic cross-sectional view of another semiconductor device provided by some examples of the present application. The semiconductor device 301 as shown in FIG. 4b is similar to the semiconductor device 300 as shown in FIG. 4a, except that the semiconductor device 301 is turned upside down and the substrate 111 in the first dicing lane block B11 in the first semiconductor structure 101 in FIG. 4a is thinned to form a first semiconductor structure 101' with a first dicing lane block B 11', and a thinned end face or a back end face of the first dicing lane block B11' facing away from the second dicing lane block B2 is in a recessed shape relative to an end face of the first device block A1 on the same side as the back end face.

In an example, as shown in FIG. 4b, the semiconductor device 301 comprises the aforementioned first semiconductor structure 101' and a semiconductor structure 201, wherein the first semiconductor structure 101' comprises the first device block A1 and the first dicing lane block B 11', the second semiconductor structure 201 comprises the second device block A2 and the second dicing lane block B2, and the first device block A1 and the second device block A2 are staked and bonded together in the second direction. The substrate 111 in the first dicing lane block B11 of FIG. 4a is partially thinned to form the first dicing lane block B11' with the thinned end face, and a height H1 of the first dicing lane block B11' is less than a height H2 of the first device block A1. Due to the presence of a height difference, the back end face or the thinned end face of the first dicing lane block B11' facing away from the second dicing lane block B2 is in a recessed shape relative to the end face of the first device block A1 on the same side as the back end face.

According to the semiconductor device 301 as shown in FIG. 4b, since the substrate 111 where the first dicing lane block B11' is located has been thinned or removed, when the external laser light is applied into the substrate 211 (e.g., the position of the focal point 215 as shown in the figure) from a side of the substrate 211 facing away from the first dicing lane block B11', the substrate will be heated and molten due to focusing of the laser light so as to generate a thermal expansion force, such that the substrate, the second dicing lane block B2 and the first dicing lane block B11' may cleave along the dicing line C-C under the tensile forces of different directions subjected by two sides of each of them. Moreover, when cleaving continues to a cross-section where the substrate 111 is located, since the substrate 111 has been thinned or removed, the dicing line C-C cleaves more easily, thereby achieving the dicing of the wafer.

It is to be noted particularly here that, although not illustrated otherwise, the substrate 111 in the example as shown in FIG. 4b may also be a material layer that is first removed and then formed again in some examples. That is, after removing the original substrate for forming the stack structure, a material layer is newly deposited on a bottom face of the stack structure where the original substrate is located, and this material layer may be, for example, a semiconductor layer formed by polysilicon. In an example, when the first device block A1 is a memory array, this semiconductor material layer may be or act as a common source layer. Thus, in some examples of the present application, the substrate 11/111/211 may be the aforementioned original substrate, or may be a base/material layer/semiconductor layer, etc. additionally formed after the original substrate is removed. That is, the substrate 111 as shown in FIG. 4b may also be a polysilicon semiconductor layer additionally formed after the original substrate is removed. Thus, the substrate in the present application includes, but is not limited to, a substrate, a base, a deposited material layer, etc. Also because the illustrated substrate may be removed in order to match different designs, the semiconductor device or the semiconductor structure in the present application may comprise a substrate. or may not comprise a substrate.

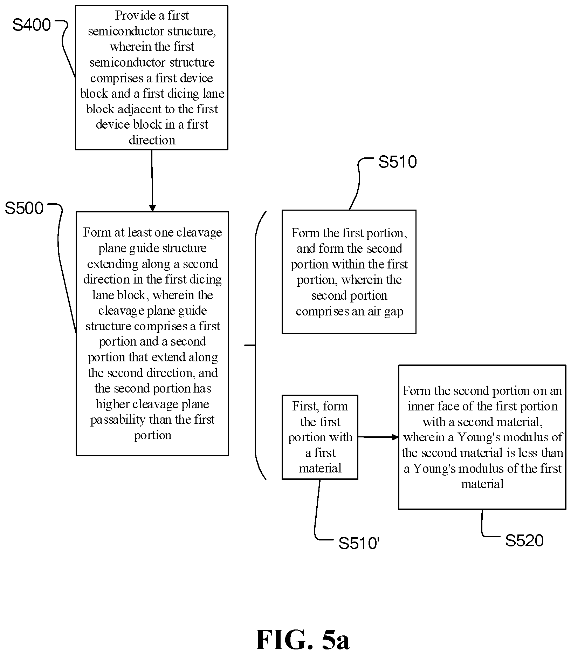

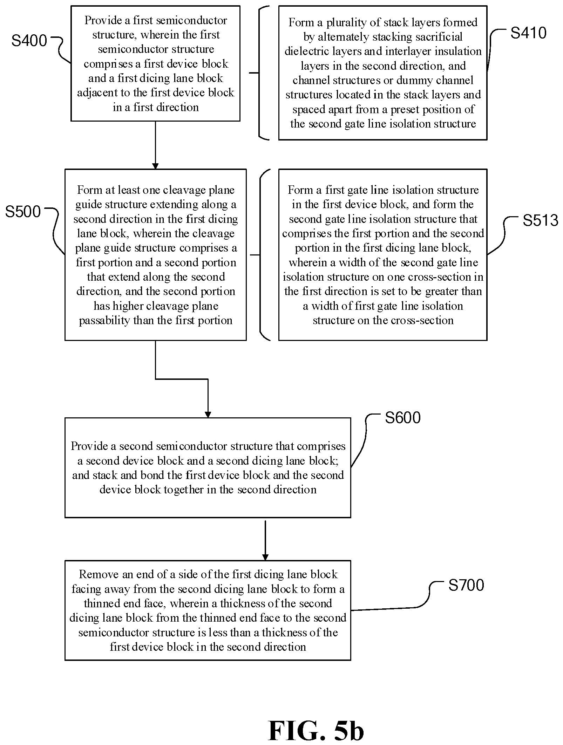

Some examples above illustrate the semiconductor device as disclosed by the present application, and the fabrication method of the semiconductor device as disclosed by the present application is further illustrated below. Referring to FIGs. 5a and 5b, FIGs. 5a and 5b are flow diagrams of a fabrication method of a semiconductor device provided by some examples of the present application.

First, as shown in FIG. 5a, the fabrication method of the semiconductor device according to some examples of the present application mainly comprises the following operations:
operation S400: providing a first semiconductor structure, wherein the first semiconductor structure comprises a first device block and a first dicing lane block adjacent to the first device block in a first direction; and
operation S500: forming at least one cleavage plane guide structure extending along a second direction in the first dicing lane block, wherein the second direction intersects the first direction, and the cleavage plane guide structure comprises a first portion and a second portion that extend along the second direction, and the second portion has higher cleavage plane passability than the first portion.

In an example, referring to the operation S400 of FIG. 5a and FIG. 1a, the first device block 12 and the first dicing lane block 13 adjacent to the first device block 12 in the first direction Y are formed on a region A of a substrate. The first device block 12 is any possible device structure, and the first dicing lane block 13 is any possible dicing lane structure formed on a region B of the substrate in order to match the device structure on the region A.

In some examples, the operation S500 may comprise:
operation S510: forming the first portion, and forming the second portion within the first portion, wherein the second portion comprises an air gap.

Referring to the operation S500 of FIG. 5a and FIG. 1a, one cleavage plane guide structure 14 extending through the dicing lane structure along the second direction Z and extending along a third direction X is formed in the first dicing lane block 13. The cleavage plane guide structure 14 comprises the first portion 14a formed by a first material that includes, but is not limited to, one of a polymer, silicon carbide (NDC), silicon nitride (SiN), ceramic (SiCN) and silicon oxide (SiO₂). The second portion 14b is an air gap that is formed at the same time as the formation of the first portion 14a of the cleavage plane guide structure 14. The air gap acting as the second portion 14b may be properly formed in the first portion 14a by properly adjusting a deposition speed of the material of the first portion 14a. As such, one of the cleavage plane guide structures 14 as described in the examples of the present application can be formed.

In some other examples, the operation S500 may comprise:
operation S510': first forming the first portion with the first material, and
operation S520: forming the second portion on an inner face of the first portion with a second material, wherein a Young's modulus of the second material is less than a Young's modulus of the first material.

In some examples, the operation S510' comprises: forming the first portion with one of a polymer, silicon carbide (NDC), silicon nitride, ceramic (SiCN) and silicon oxide; the operation S520 comprises: forming the second portion with a material selected from one of a polymer, silicon carbide (NDC), silicon nitride, ceramic (SiCN) and silicon oxide, wherein the second material is different from the first material, and the Young's modulus of the second material is less than the Young's modulus of the first material.

In an example, referring to FIG. 1b, the first device block 12 and the first dicing lane block 13 adjacent to the first device block 12 in the first direction Y are formed on the region A of the substrate. The first device block 12 is any possible device structure, and the first dicing lane block 13 is any possible dicing lane structure formed on the region B of the substrate in order to match the device structure on the region A.

Referring to the operation S510' of FIG. 5a and FIG. 1b again, a first portion 14a' extending through the dicing lane structure along the second direction Z and extending along the third direction X is formed in the first dicing lane block 13. Referring to FIG. 1b and the operation S520 again, a second portion 14b' is formed on an inner face of the first portion 14a' with the second material, and the Young's modulus of the second material is less than the Young's modulus of the first material. The first material or the second material includes, but is not limited to, one of a polymer, silicon carbide (NDC), silicon nitride, ceramic (SiCN) and silicon oxide (SiO₂). As such, one of the cleavage plane guide structures 14 as described in the examples of the present application can be formed.

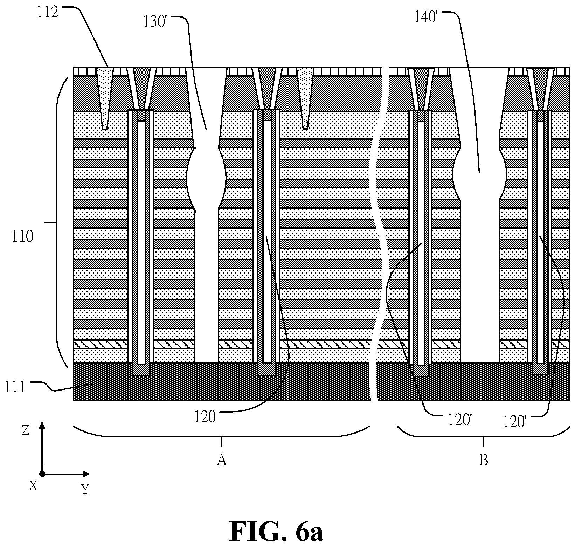

Referring to FIGs. 5b and 6a-6d, the fabrication method of the semiconductor device 101 will be further illustrated below by taking fabrication of the above-mentioned semiconductor device 101 as an example. That is, in some examples, as shown in FIG. 5b, the aforementioned operation S400 may comprise:
operation S410: forming a plurality of stack layers formed by alternately stacking sacrificial dielectric layers and interlayer insulation layers in the second direction, and channel structures or dummy channel structures located in the stack layers and spaced apart from a preset position of a second gate line isolation structure, so as to form the first dicing lane block.

In some examples, the operation S500 may comprise:
operation S513: forming a first gate line isolation structure in the first device block; and forming, in the first dicing lane block, the second gate line isolation structure that acts as the cleavage plane guide structure and comprises the first portion and the second portion, wherein a width of the second gate line isolation structure on one cross-section in the first direction is set to be greater than a width of the first gate line isolation structure on the cross-section.

Since the width of the second gate line isolation structure on one cross-section in the first direction is greater than the width of the first gate line isolation structure on the cross-section, during formation of the gate line isolation structure, it is achieved that, the first gate line isolation structure in the device is fully filled, but an obvious air gap is formed in the special second gate line isolation structure of the dicing lane block, that is, the air gap as described in the operation S510 is formed in the second gate line isolation structure.

In some examples, the operation S513 may further comprise: forming a plurality of the second gate line isolation structures, wherein the plurality of second gate line isolation structures are disposed as being spaced apart from the channel structures or the dummy channel structures in the first direction.

In an example, first as shown in the operation S410 of FIG. 5b and FIG. 6a, a stack structure 110 and a stack structure 110', the plurality of channel structures 120 penetrating through the stack structure 110, channel structures or dummy channel structures 120' penetrating through the stack structure 110', top gate isolation structures 112, a first gate line slit 130' and a second gate line slit 140' are respectively formed on a first device region A on the substrate 111 and a first dicing lane region B adjacent to the first device region A in the first direction Y. The stack structure 110 comprises gate layers and interlayer insulation layers (not numbered) stacked alternately, wherein the gate layers include, but are not limited to, tungsten, cobalt, copper, aluminum, doped silicon or doped silicide, and the interlayer insulation layers include, but are not limited to, a combination of any of one or more of silicon oxide, silicon nitride and silicon oxynitride. The number of the gate layers and the interlayer insulation layers may be any number and is not limited.

It is to be noted here that, the stack structure 110 is formed by first forming, on the regions A and B of the substrate 111, the stack layers formed by the sacrificial dielectric layers and the interlayer insulation layers stacked alternately, then forming the channel structures 120 and 120' and the top gate isolation structures 112 in the stack layers, then forming the first gate line slit 130' and the second gate line slit 140' by cutting grooves, and then replacing the sacrificial dielectric layers with the gate layers through the first gate line slit 130' and the second gate line slit 140'. Therefore, the channel structures or the dummy channel structures are formed at positions in the stack layers spaced apart from the preset position of the second gate line isolation structure.

Moreover, a formation process of the channel structures 120 penetrating through the stack layers along a stacking direction (Z) (i.e., the second direction) is, for example, first forming channel holes in the stack layers, and then in the channel holes, forming a storage medium layer, a channel layer located in the storage medium layer and a channel filling layer located in the channel layer. The storage medium layer may comprise a tunneling layer disposed around the channel layer, a charge storage layer disposed around the tunneling layer, and a charge blocking layer disposed around the charge storage layer. The channel filling layer may comprise an oxide, such as silicon oxide, silicon nitride, silicon oxynitride, etc. The channel layer may comprise a semiconductor layer, such as polysilicon. The tunneling layer may comprise an oxide, such as silicon oxide, silicon nitride, silicon oxynitride, etc. The charge storage layer may comprise an insulation layer including a compound containing quantum dots or nanocrystals or containing nitrogen and silicon. The charge blocking layer may comprise an oxide, such as silicon oxide, etc. The top gate isolation structures 112 are distributed in the top gate layer for paging of the channel structures 120. A material of the top gate isolation structures 112 may include, but not be limited to, a dielectric insulation material, such as silicon oxide, silicon nitride, etc.

In addition, although the stack structures 110 and 110' as enumerated in some examples are both formed by the gate layers and the interlayer insulation layers stacked alternately, it is to be understood that the sacrificial dielectric layers in the first dicing lane block B11 may not be replaced by the conductive gate layers. Particularly in the example as shown in FIG. 2a, when no channel structure is disposed in the first dicing lane block B1, or the dicing lane is wide, part of the sacrificial dielectric layers may be still remained. Thus, the gate layers here should be interpreted as comprising the sacrificial dielectric layers or the conductive gate layers after replacement.

In addition, it is to be noted particularly that: a width of the second gate line slit 140' on one cross-section in the first direction Y is set to be greater than a width of the first gate line slit 130' on the cross-section, i.e., like the first width W1 and the second width W2 as shown in FIG. 2a. Through such a setting, during subsequent formation of the second gate line isolation structure 140, the second gate line isolation structure 140 comprising the air gap may be formed in the second gate line isolation structure 140', and the first gate line slit 130' can also be fully filled to form the first gate line isolation structure 130.

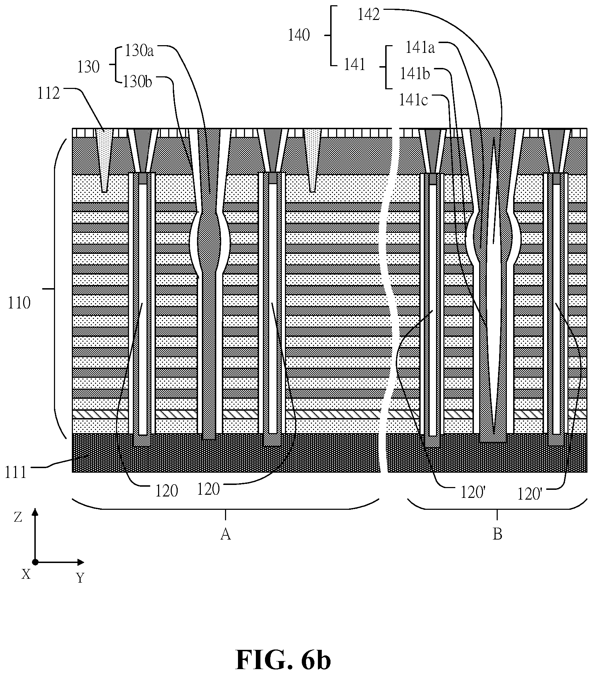

Next, as shown in FIG. 6b, the first gate line isolation structure 130 and the second gate line isolation structure 140 are filled into the first gate line slit 130' and the second gate line slit 140' respectively. The first gate line isolation structure 130 may comprise a filling layer 130a and a barrier layer 130b. A material of the barrier layer 130b may comprise at least one of silicon oxide, silicon nitride, silicon oxynitride, doped silicon oxide, organosilicate glass, and other materials. A material of the filling layer 130a may include, but not be limited to, a polymer material such as polysilicon, etc. The second gate line isolation structure 140 comprises a first portion 141 and a second portion 142, wherein the second portion 142 is an air gap. The first portion 141 is the same as the first gate line isolation structure 130, and thus comprises a filling layer 141a, and an oxidization layer 141b isolating the filling layer 141a from the stack structure 110'. A material of the first portion 141 may be the same as a material of the first gate line isolation structure 130, but a material of the filling layer 141a in the oxidization layer 141b may also include, but not be limited to, one of a polymer, silicon carbide (NDC), silicon nitride, ceramic (SiCN) and silicon oxide. That is, the first portion 141 may be formed simultaneously with the first gate line isolation structures 130 and uses the same material as the first gate line isolation structures 130, but may be also formed separately by using a material different from that of the first gate line isolation structures 130.

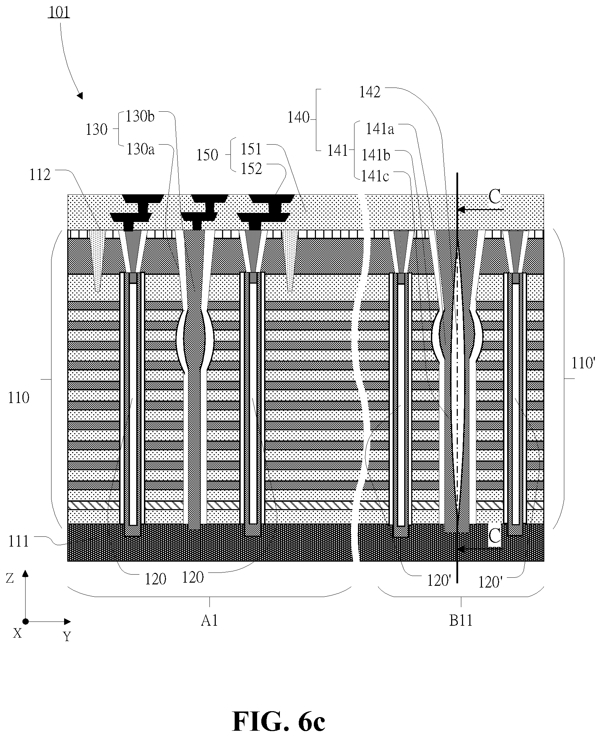

Next, as shown in FIG. 6c, an interconnection layer 150 is formed on the stack structures 110 and 110', so as to form the semiconductor device 101 comprising the first device block A1 and the first dicing lane block B11 as shown in FIG. 2b. The interconnection layer 150 is mainly distributed on the first device block A1, but may also be distributed on the first dicing lane block B11, and the interconnection layer 150 comprises a dielectric layer 151 and conductive lines or conductors 152 in the dielectric layer 151. The material and functions of the interconnection layer 150 have been described previously, and are no longer repeated here.

In some examples, as described previously, the operation S513 may further comprise: forming a plurality of the second gate line isolation structures, wherein the plurality of second gate line isolation structures are disposed as being spaced apart from the channel structures or the dummy channel structures in the first direction. In an example, there are a plurality of the second gate line slits 140' as shown in FIG. 6a, and the plurality of second gate line slits 140' are disposed as being spaced apart from the channel structures or the dummy channel structures in the first direction Y. Thus, the structure, which is equivalent to the structure as shown in FIG. 2c, can be formed. Hence, the structure formed by this operation is no longer illustrated.

In addition, as shown in FIG. 5b, the fabrication method of the semiconductor device according to some examples of the present application further comprises:
operation S600: providing a second semiconductor structure that comprises a second device block and a second dicing lane block; and stacking and bonding the first device block and the second device block together in the second direction.

In some examples, the operation S600 further comprises: providing a silicon substrate, wherein the second dicing lane block comprises the silicon substrate.

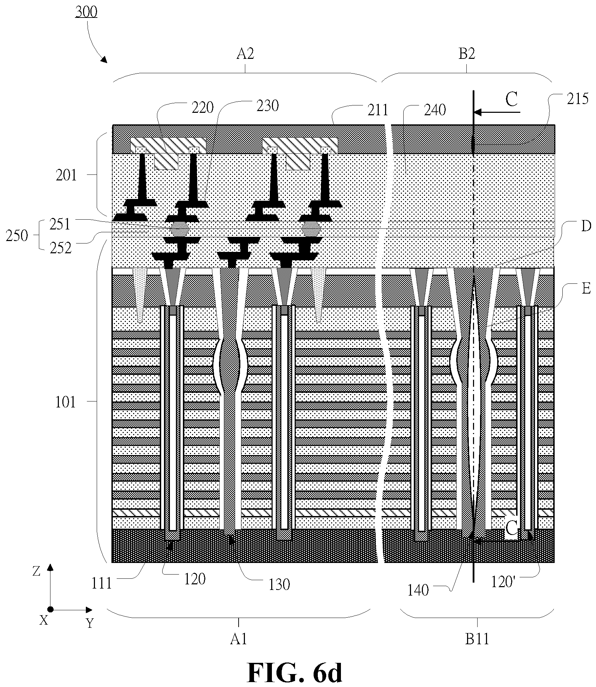

In an example, in the operation S600, first, the second semiconductor structure 201 as shown in FIG. 6d is provided. Providing the second semiconductor structure 201 comprises: forming second devices 220 on the substrate 211, and depositing a dielectric layer 240 and a conductive route 230 alternately to form the second device block A2 and the second dicing lane block B2. The dielectric layer 240 covers the second devices 220 and acts as interlayer insulation, and the conductive route 230 is distributed in the dielectric layer 240 and connected with each of the second devices 220. A material of the substrate 211 is the same as that of the substrate in the first semiconductor structure 101, and may comprise monocrystalline silicon, polysilicon, monocrystalline germanium, a group III-V compound semiconductor material, a group II-VI compound semiconductor material or other semiconductor materials, etc., which is no longer repeated here. The substrate 211 extends into the second device block A2 and the second dicing lane block B2.

After forming the second semiconductor structure 201, bonding layers are formed on the first semiconductor structure 101 and the second semiconductor structure 201 respectively, and each of the bonding layers comprises bonding contacts 251 and a dielectric layer 252. Next, after the second semiconductor structure 201 is inverted on the first semiconductor structure 101 through a bonding process and pressurized hot melting is performed, a bonding structure 250 between the first semiconductor structure 101 and the second semiconductor structure 201 is formed, so that the first semiconductor structure 101 and the semiconductor structure 201 are bonded together. As such, the semiconductor device 300 as shown in FIG. 6d (i.e., FIG. 4a) is formed.

Next, the fabrication method of the semiconductor device according to some examples of the present application further comprises:
operation S700: removing an end of a side of the first dicing lane block facing away from the second dicing lane block to form a first dicing lane block with a thinned end face, wherein a thickness of the first dicing lane block with the thinned end face in the second direction is less than a thickness of the first device block in the second direction.

In an example, the end of the side of the first dicing lane block B11 facing away from the second dicing lane block B2 as shown in FIG. 4a is removed in the operation S700, so as to form the first dicing lane block B11' structure with the thinned end face, as shown in FIG. 4b (since the structure at this point is the same as that in FIG. 4b, FIG. 4b is directly cited without further illustrations). As such, the thickness of the first dicing lane block B11' with the thinned end face in the second direction Z is less than the thickness of the first device block A1 in the second direction Z. In this operation, the substrate of the first device block A1 region may be blocked by a mask, and the substrate or part of the substrate on the side of the first dicing lane block B11 facing away from the second dicing lane block B2 is removed by an anisotropic etching method, so as to achieve the objective of thinning, thereby forming the first dicing lane block B11' with the thinned end face.

It is to be noted here that, as the same as described in the aforementioned structure, the illustrated substrate may be also removed, and then a semiconductor layer is deposited as a common source layer. Thus, the thinned substrate may also be the semiconductor layer deposited later. In addition, when the semiconductor device is not provided with the second semiconductor structure, the thinned substrate may be also the substrate in the first semiconductor structure. That is, the substrate is thinned to such a thickness that the substrate easily cleaves after laser exposure.

According to the fabrication method of the semiconductor device as shown in some examples above, finally, when the external laser light is applied into the substrate 211 (e.g., the position of the focal point 215 as shown in FIGs. 4a and 4b) from a side of the substrate 211 facing away from the first dicing lane block B11B11', the substrate 211 will be heated and molten due to focusing of the laser light so as to generate a thermal expansion force. Next, as long as two sides of each of the substrate 211, the second dicing lane block B2 and the first dicing lane block B11/B11' are subjected by tensile forces of different directions, the substrate 211, the second dicing lane block B2 and the first dicing lane block B11/B11' may cleave along the dicing line C-C, so that the dicing of the wafer is achieved, and the semiconductor device is made.

According to some examples of the present application, the present application further provides a memory comprising:
a memory array comprising the first semiconductor structure or the second semiconductor structure in the aforementioned semiconductor device; and a peripheral circuit comprising the first semiconductor structure or the second semiconductor structure in the aforementioned semiconductor device.

Finally, according to some examples of the present application, the present application further provides a memory system comprising:
the aforementioned memory; and a control device configured to control operations of the memory.

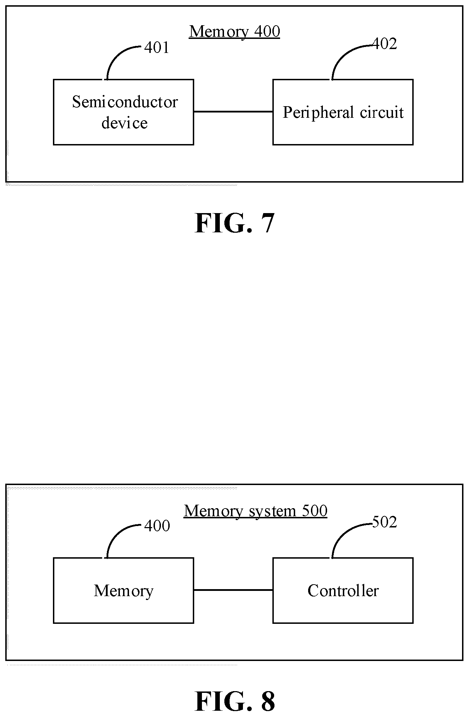

Referring to FIG. 7, FIG. 7 is a block diagram of a memory provided by some examples of the present application. The memory 400 may be a three-dimensional memory, such as a 3D NAND memory, a 3D NOR memory, a 3D DRAM memory, etc.

The memory 400 comprises a semiconductor device 401 and a peripheral circuit 402. The semiconductor device 401 may be the first semiconductor structure 100/101/102 or the second semiconductor structure 201 in the above examples (when the memory has a 2D structure), and the peripheral circuit 402 may be the first semiconductor structure 10/10' or the second semiconductor structure 201 in the above examples, which is typically a COMS (complementary metal oxide semiconductor) structure. The peripheral circuit 402 is connected with the semiconductor device 401 so as to communicate signals with the semiconductor device 401. The peripheral circuit 402 may be configured for logic operation, and controls and detects on/off states of all memory cells in the above-mentioned semiconductor device 401, so as to achieve storage and reading of data. Therefore, the memory 400 may be also the aforementioned semiconductor device 300/301 comprising the first semiconductor structure 100/101/102 and the second semiconductor structure 201.

In the aforementioned memory 400, the semiconductor device 401 comprises a first device block and a first dicing lane block adjacent to the first device block in a first direction. Moreover, the first dicing lane block comprises at least one cleavage plane guide structure extending along a second direction that intersects the first direction; the cleavage plane guide structure comprises a first portion and a second portion that extend along the second direction and are at least partially in juxtaposition, and the second portion has higher cleavage plane passability than the first portion, so that the memory has a good dicing lane.

Referring to FIG. 8, FIG. 8 is a block diagram of a memory system provided by some examples of the present application. The memory system 500 comprises a memory 400 and a controller 502. The memory 400 may be the memory in the aforementioned examples, and may comprise any one semiconductor device in various examples above, that is, the memory 400 may be memory 400 as shown in FIG. 7. The controller 502 is connected with the memory 400 and configured to control the memory 400 to store data, and the memory 400 may perform the operation of storing the data based on the control of the controller 502.

In some implementations, the memory system may be implemented as, for example, a Universal Flash Storage (UFS) device, a solid-state drive (SSD), a multi-media card in MMC, eMMC, RS-MMC and micro-MMC forms, a secure digital card in SD, mini-SD and micro-SD forms, a memory device of a Personal Computer Memory Card International Association (PCMCIA) card type, a memory device of a Peripheral Component Interconnection (PCI) type, a memory device of a PCI-Express (PCI-E) type, a Compact Flash (CF) card, a smart media card, or a memory stick, etc.

According to the semiconductor device and the fabrication method thereof, and the memory and the memory system as disclosed in some examples of the present application as described above, a cleavage plane guide structure is designed on the dicing lane, and the first portion and the second portion with different levels of cleavage easiness are disposed in the cleavage plane guide structure, with the second portion having higher cleavage plane passability than the first portion. By such a configuration, during a stealth dicing before grinding (SDBG) process, cleavage in the dicing lane block will first pass through the second portion, thereby avoiding the situation that a large amount of metal in the dicing lane block cannot break apart in the traditional solution, and thus increasing the dicing yield of products without increasing the costs.

In conclusion, the semiconductor device and the fabrication method thereof, and the memory and the memory system as disclosed in some examples of the present application have been disclosed above, but the above examples are not to limit the present application. Those of ordinary skill in the art may make various alterations and modifications without departing from the spirit and the scope of the present application. The present application may have other implementations in addition to the above examples. Any technical solution formed by identical replacement or equivalent replacement falls within the protection scope as claimed by the present application. Therefore, the protection scope of the present application is defined by the scope as defined by the claims.

## Claims

1. A semiconductor device, comprising:
a first semiconductor structure that comprises a first device block and a first dicing lane block adjacent to the first device block in a first direction,
wherein the first dicing lane block comprises at least one cleavage plane guide structure extending along a second direction that intersects the first direction, and the cleavage plane guide structure comprises a first portion and a second portion that extend along the second direction, and the second portion has higher cleavage plane passability than the first portion.

2. The semiconductor device of claim 1, wherein the second portion comprises an air gap.

3. The semiconductor device of claim 2, wherein the first portion comprises two ends in the second direction, and comprises a first curved surface interfacing with the second portion, and the first curved surface is recessed toward the first portion relative to the two ends in the first direction.

4. The semiconductor device of claim 2, wherein the first portion comprises two ends in the second direction, and the second portion comprises a gap between a virtual cross-section formed by the two ends of the first portion and the first portion.

5. The semiconductor device of claim 2, wherein the first portion comprises a first material that includes one of a polymer, silicon carbide (NDC), silicon nitride, ceramic (SiCN) and silicon oxide.

6. The semiconductor device of claim 1, wherein the first portion comprises a first material, the second portion comprises a second material, and a Young's modulus of the second material is less than a Young's modulus of the first material.

7. The semiconductor device of claim 6, wherein the first material or the second material includes one of a polymer, silicon carbide (NDC), silicon nitride, ceramic (SiCN) and silicon oxide.

8. The semiconductor device of claim 1, wherein the first device block comprises a first gate line isolation structure, the cleavage plane guide structure comprises a second gate line isolation structure that comprises the first portion and the second portion, and a width of the second gate line isolation structure on one cross-section in the first direction is greater than a width of the first gate line isolation structure on the cross-section.

9. The semiconductor device of claim 8, wherein the first dicing lane block comprises a plurality of stack structures formed by alternately stacking gate layers and interlayer insulation layers in the second direction, and channel structures or dummy channel structures located in the stack structures and spaced apart from the second gate line isolation structure.

10. The semiconductor device of claim 9, wherein the first dicing lane block comprises a plurality of the channel structures or dummy channel structures and a plurality of the second gate line isolation structures, and the plurality of channel structures or dummy channel structures are alternately disposed as being spaced apart from the plurality of second gate line isolation structures in the first direction.

11. The semiconductor device of claim 1, wherein the first dicing lane block comprises a first X dicing lane block adjacent to the first device block in the first direction, and a first Y dicing lane block adjacent to the first device block in a third direction that intersects the first direction; and the cleavage plane guide structure comprises a first X cleavage plane guide structure on the first X dicing lane block, and a first Y cleavage plane guide structure on the first Y dicing lane block.

12. The semiconductor device of claim 1, wherein the cleavage plane guide structure comprises a first end in the second direction and one narrowed portion away from the first end, and a cross-sectional area of the cleavage plane guide structure in the first direction is gradually enlarged in a direction from the narrowed portion to the first end.

13. The semiconductor device of claim 1, further comprising:
a second semiconductor structure, wherein the second semiconductor structure comprises a second device block and a second dicing lane block, and the first device block and the second device block are stacked and bonded together in the second direction.

14. The semiconductor device of claim 13, wherein the second dicing lane block comprises a silicon substrate.

15. The semiconductor device of claim 13, wherein the cleavage plane guide structure comprises a first end in the second direction and one narrowed portion away from the first end, and a cross-sectional area of the cleavage plane guide structure in the first direction is gradually enlarged in a direction from the narrowed portion to the first end; and compared with the narrowed portion, the first end is closer to the second dicing lane block of the second semiconductor device.

16. The semiconductor device of claim 13, wherein the first dicing lane block has a first thickness, the first device block has a second thickness that is greater than the first thickness, and a back end face of the first dicing lane block facing away from the second dicing lane block is in a recessed shape relative to an end face of the first device block on the same side as the back end face.

17. A fabrication method of a semiconductor device, comprising:
providing a first semiconductor structure, wherein the first semiconductor structure comprises a first device block and a first dicing lane block adjacent to the first device block in a first direction; and
forming at least one cleavage plane guide structure extending along a second direction in the first dicing lane block, wherein the second direction intersects the first direction, and the cleavage plane guide structure comprises a first portion and a second portion that extend along the second direction, and the second portion has higher cleavage plane passability than the first portion.

18. The fabrication method of the semiconductor device of claim 17, wherein the forming the cleavage plane guide structure comprises: forming the first portion, and forming the second portion within the first portion, wherein the second portion comprises an air gap.

19. The fabrication method of the semiconductor device of claim 18, wherein the forming the cleavage plane guide structure comprises: forming the first portion with a first material including one of a polymer, silicon carbide (NDC), silicon nitride, ceramic (SiCN) and silicon oxide.

20. The fabrication method of the semiconductor device of claim 17, wherein the forming the cleavage plane guide structure comprises: first forming the first portion with a first material, and then forming the second portion with a second material on an inner face of the first portion, wherein a Young's modulus of the second material is less than a Young's modulus of the first material.

21. The fabrication method of the semiconductor device of claim 20, wherein the forming the first portion with the first material comprises: forming the first portion with one of a polymer, silicon carbide (NDC), silicon nitride, ceramic (SiCN) and silicon oxide; and the forming the second portion with the second material comprises: forming the second portion with one of a polymer, silicon carbide (NDC), silicon nitride, ceramic (SiCN) and silicon oxide.

22. The fabrication method of the semiconductor device of claim 17, wherein the forming the cleavage plane guide structure comprises: forming a first gate line isolation structure in the first device block; and forming, in the first dicing lane block, a second gate line isolation structure that acts as the cleavage plane guide structure and comprises the first portion and the second portion, wherein a width of the second gate line isolation structure on one cross-section in the first direction is set to be greater than a width of the first gate line isolation structure on the cross-section.

23. The fabrication method of the semiconductor device of claim 22, wherein the forming the first dicing lane block comprises: forming a plurality of stack layers formed by alternately stacking sacrificial dielectric layers and interlayer insulation layers in the second direction, and channel structures or dummy channel structures located in the stack layers and spaced apart from a preset position of the second gate line isolation structure.

24. The fabrication method of the semiconductor device of claim 23, wherein the forming the cleavage plane guide structure comprises: forming a plurality of the second gate line isolation structures, wherein the plurality of second gate line isolation structures are disposed as being spaced apart from the channel structures or the dummy channel structures in the first direction.

25. The fabrication method of the semiconductor device of claim 17, further comprising: providing a second semiconductor structure that comprises a second device block and a second dicing lane block; and stacking and bonding the first device block and the second device block together in the second direction.

26. The fabrication method of the semiconductor device of claim 25, wherein the providing the second semiconductor structure comprises: providing a silicon substrate, wherein the second dicing lane block comprises the silicon substrate.

27. The fabrication method of the semiconductor device of claim 25, further comprising: removing an end of a side of the first dicing lane block facing away from the second dicing lane block to form a first dicing lane block with a thinned end face, wherein a thickness of the first dicing lane block with the thinned end face in the second direction is less than a thickness of the first device block in the second direction.

28. A memory, comprising:
a memory array comprising the first semiconductor structure or the second semiconductor structure in the semiconductor device of any one of claims 1 to 16, and
a peripheral circuit comprising the first semiconductor structure or the second semiconductor structure in the semiconductor device of any one of claims 1 to 7 and 13 to 16.

29. A memory system, comprising:
the memory of claim 28; and
a control device configured to control operations of the memory.
